# EUROPEAN PATENT APPLICATION

(11) **EP 4 808 290 A1**
(43) Date of publication of application: **16.09.2026**
(21) Application number: 26163585.8
(22) Date of filing: 10.03.2026
(51) Int. Cl.: H05K 1/02, H05K 7/20

(54) **POWER CONVERSION APPARATUS AND POWER CABINET**

(30) Priority: 10.03.2025 CN 202510288880
(71) Applicant: HUAWEI TECHNOLOGIES CO., LTD., Shenzhen 518129 (CN)
(72) Inventor: HOU, Zhaozheng, Shenzhen, Guangdong, 518129 (CN); CAO, Wenyuan, Shenzhen, Guangdong, 518129 (CN); JIANG, Hongxu, Shenzhen, Guangdong, 518129 (CN); YANG, Xuming, Shenzhen, Guangdong, 518129 (CN); ZHAO, Jijian, Shenzhen, Guangdong, 518129 (CN); JIANG, Zhengdong, Shenzhen, Guangdong, 518129 (CN)
(74) Representative: Maiwald GmbH

(57) **Abstract**

Embodiments of this application provide a power conversion apparatus and a power cabinet including the power conversion apparatus, and relate to the field of energy technologies. The power conversion apparatus is configured to perform power conversion on input electric energy for output. The power conversion apparatus includes an apparatus housing, a circuit board, a power device, and a substrate. The circuit board is fastened in the apparatus housing. The power device is fastened to the circuit board. The substrate is located in the apparatus housing. The substrate includes a first metal layer, a first insulation layer, and a second metal layer. The first insulation layer is fastened between the first metal layer and the second metal layer. The first metal layer is connected to the circuit board or the power device.

## Description

### TECHNICAL FIELD

This application relates to the field of energy technologies, and in particular, to a power conversion apparatus and a power cabinet.

### BACKGROUND

A power conversion apparatus is widely used in various power systems. A power device is a core of hardware design of the power conversion apparatus. However, the power device generates a considerable amount of heat during operation of the power conversion apparatus.

In a related technology, to effectively dissipate heat from the power device, a part of a heat sink goes through a circuit board and then is soldered to the power device. In this heat dissipation solution, however, the heat sink and the power device are directly electrically connected and become electrified. When the heat sink carries electrical levels with high-low transitions, interference is caused to a signal (for example, a signal from a drive circuit used to drive the power device, or a signal from a control circuit used to control the power device).

### SUMMARY

This application provides a power conversion apparatus and a power cabinet including the power conversion apparatus, to reduce interference to a signal while effectively dissipating heat from a power device.

To achieve the foregoing objective, this application uses the following technical solutions.

According to a first aspect of this application, a power conversion apparatus is provided to perform power conversion on input electric energy for output. The power conversion apparatus includes an apparatus housing, a circuit board, a power device, and a substrate. The circuit board is fastened in the apparatus housing. The power device is fastened to the circuit board. The substrate is located in the apparatus housing. The substrate includes a first metal layer, a first insulation layer, and a second metal layer. The first insulation layer is fastened between the first metal layer and the second metal layer. The first metal layer is connected to the circuit board or the power device.

The power conversion apparatus implements power conversion on the input electric energy by using the power device on the circuit board. During operation of the power conversion apparatus, the power device generates a considerable amount of heat, and the substrate can help with heat dissipation of the power device. Both the first metal layer and the second metal layer in the substrate have a strong heat conduction capability (metal has a good heat conduction capability), so that heat from the power device can be transferred outward through the substrate, thereby effectively improving a heat dissipation effect of the power device. For example, when the substrate is connected to the power device, the heat from the power device is transferred to the substrate, and then transferred outward through the substrate. For another example, when the substrate is connected to the circuit board, the heat from the power device is transferred to the circuit board, then transferred to the substrate through the circuit board, and finally transferred outward through the substrate.

Moreover, the first insulation layer of the substrate can separate the first metal layer from the second metal layer. This reduces a possibility that the first metal layer and the second metal layer are electrically connected to each other. When the first metal layer is electrified (for example, the circuit board or the power device is electrically connected to the first metal layer), a possibility that the second metal layer and a structure connected to the second metal layer (for example, a heat sink) are electrified can be reduced through the first insulation layer, thereby reducing interference to a signal (for example, a signal from a drive circuit used to drive the power device, or a signal from the control circuit used to control the power device). In conclusion, the substrate in this application can help with heat dissipation of the power device, which effectively dissipates the heat from the power device while reducing a risk of interference to a signal caused by the second metal layer being electrified (and the structure connected to the second metal layer being electrified).

In an embodiment of this application, the substrate is located on a side that is of the circuit board and that is away from the power device, the circuit board includes a first routing layer facing the power device and a second routing layer facing the substrate, the power device is fastened to the first routing layer, and the second routing layer is connected to the first metal layer.

The power device is fastened to the first routing layer of the circuit board, so that the power device is connected to a power conversion circuit of the power conversion apparatus. The second routing layer of the circuit board is connected to the first metal layer of the substrate. A material of the second routing layer is metal, and the metallic second routing layer can be soldered to the metallic first metal layer. This facilitates stable connection between the substrate and the circuit board, reducing a possibility that the substrate is separated from the circuit board. In addition, through soldering, thermal resistance between the substrate and the circuit board may also be small, which facilitates heat transfer between the substrate and the circuit board.

In an embodiment of this application, the first metal layer is connected to a board surface that is of the circuit board and that is away from the power device, the circuit board includes a through hole, one port of the through hole faces the power device, and the other port of the through hole faces the first metal layer.

The through hole between the power device and the first metal layer can accelerate heat conduction between the power device and the substrate. In this way, the heat from the power device can be quickly transferred across the circuit board to the first metal layer of the substrate, and then the heat is transferred outward through the substrate, thereby improving heat dissipation efficiency of the power device.

In an embodiment of this application, an inner surface of the through hole includes a metal structure, and the metal structure extends out of the through hole and is connected to the first metal layer.

The through hole is a metal hole, and the metal structure is connected (for example, soldered) to the first metal layer. The metal hole has a stronger heat conduction capability. The metal structure helps with heat dissipation of the power device, so that heat transfer between the power device and the substrate can be accelerated. In this way, the heat from the power device is transferred to the substrate more quickly through the metal structure, which further improves heat dissipation efficiency of the power device.

In an embodiment of this application, there is a filler in the through hole. The filler includes a metal block, and the metal block is connected to the first metal layer; or the filler includes resin.

When the filler is a metal block, the metal block is connected to the first metal layer. The metal block is made of metal and has a strong heat conduction capability. In this way, the metal block can help the through hole conduct the heat from the power device, thereby improving heat dissipation efficiency of the power device. When the filler is resin, because the resin has a stronger heat conduction capability than air, the heat from the power device can be transferred to the substrate through the resin and heat transfer can be accelerated.

In addition, the filler can seal the through hole. For example, when the through hole goes through a pad on the circuit board (the pad is a part of the routing layer on the circuit board and is used for soldering the power device), the filler can reduce a possibility that solder on the pad enters the through hole, so that there is more solder between the power device and the pad. This facilitates stable connection between the power device and the circuit board.

In an embodiment of this application, the power device includes a packaging housing and a metal plate, the metal plate protrudes from the inside of the packaging housing to a side that is of the packaging housing and that is away from the circuit board, the substrate is located on a side that is of the power device and that is away from the circuit board, and the metal plate is connected to the first metal layer.

The substrate may alternatively be connected to the power device, so that the heat from the power device is directly transferred to the substrate (without passing through the circuit board), and then transferred outward through the substrate. This shortens a heat dissipation path of the power device and improves a heat dissipation effect of the power device. In addition, the metal plate of the power device can help the power device dissipate heat outward, so that heat inside the packaging housing is quickly transferred to the outside of the packaging housing through the metal plate. In other words, the heat inside the packaging housing is quickly transferred to the substrate, thereby improving heat dissipation efficiency of the power device.

In an embodiment of this application, the substrate further includes a second insulation layer and a third metal layer, and the second insulation layer is fastened between the second metal layer and the third metal layer.

In some cases, one side of the substrate needs to be connected to the power device or the circuit board, and the other side of the substrate may be connected to an auxiliary heat dissipation structure such as the heat sink. Therefore, materials of the first metal layer, the second metal layer, and the third metal layer may be separately selected. For example, materials of metal layers on two sides of the substrate (the material of the first metal layer and the material of the third metal layer) are materials conducive to soldering (for example, copper); and a material of a metal layer at the middle of the substrate (the material of the second metal layer) is a material with a lower cost (for example, aluminum), or the material of the second metal layer is a material with a lighter weight. The substrate includes a plurality of metal layers (the first metal layer, the second metal layer, and the third metal layer). Different materials may be selected for different metal layers according to a requirement. This facilitates connection (for example, soldering) between the substrate and another structure, with other factors such as cost, weight, and heat conduction capability of the substrate taken into consideration, allowing for a more flexible design of the substrate.

In addition, disposing a plurality of insulation layers (the first insulation layer and the second insulation layer) may further reduce a possibility that a structure connected to the third metal layer of the substrate (for example, the heat sink) is electrified, and further reduce a risk of interference to a signal caused by another structure being electrified.

In an embodiment of this application, the power conversion apparatus includes a heat sink. The heat sink is located in the apparatus housing or is at least partially outside the apparatus housing. The heat sink includes a heat conducting plate and a plurality of fins. The heat conducting plate is located on a side that is of the substrate and that is away from the power device, and is fastened to the substrate. The plurality of fins are fastened to a surface that is of the heat conducting plate and that is away from the substrate.

The substrate is connected (for example, soldered) to the heat conducting plate of the heat sink, so that the heat sink can help the substrate dissipate heat. After the heat from the power device is transferred to the substrate, the heat is transferred to the heat conducting plate of the heat sink through the substrate, and the heat is transferred from the heat conducting plate to the plurality of fins. A gap between two adjacent fins facilitates heat exchange between the fins and air, thereby improving heat dissipation efficiency of the power device.

In addition, if a boss (a structure similar to a fin) is directly formed on the substrate, a length of the boss (a size of the boss in a thickness direction on the second metal layer) may be short due to a limitation of a manufacturing device of the substrate, which affects a heat dissipation effect of the power device. In addition, in the foregoing design manner, to make the length of the boss to meet a heat dissipation requirement of the power device, manufacturing costs are inevitably greatly increased. However, the heat sink is additionally provided, so that the heat sink can be independently produced according to a requirement. In this way, a size and a shape of the heat sink are more flexible, which is conducive to production and manufacturing. As a result, manufacturing costs are reduced while effective heat dissipation of the power device is maintained.

In addition, because the substrate includes a first insulation layer, a possibility that a first metal layer and a second metal layer are electrically connected to each other can be reduced through the first insulation layer, thereby reducing a possibility that the heat sink connected to the second metal layer is electrified, and reducing a risk of interference to a signal caused by the heat sink being electrified. In scenarios such as salt fogs and wet dust, a risk of a short circuit between different electrical networks on the circuit board and the heat sink is also reduced.

In an embodiment of this application, a thickness of the first metal layer and a thickness of the second metal layer are both greater than a thickness of the first insulation layer.

Both the first metal layer and the second metal layer in the substrate have a strong heat conduction capability, and the first insulation layer for shielding has a weak heat conduction capability. Therefore, in some scenarios, the thickness of the first metal layer and the thickness of the second metal layer may be increased, and the thickness of the first insulation layer may be decreased, to improve a heat conduction capability of the substrate and facilitate heat dissipation of the power device.

In an embodiment of this application, a material of the first insulation layer includes polypropylene.

Polypropylene (PP) has good insulation performance, and has a stronger heat conduction capability than another insulation material (for example, polyimide). The first insulation layer of the substrate includes polypropylene. In this way, the first metal layer and the second metal layer are insulated from each other, thermal resistance between the first metal layer and the second metal layer is reduced, and a heat dissipation capability of the substrate is improved.

In an embodiment of this application, the circuit board includes a pad configured to connect to a power device, and a pin of the power device is fastened to a surface that is of the pad and that faces the power device.

The power device is in a form of a surface-mount device. This facilitates development of the power device toward miniaturization and high density, and can also improve reliability of the power device. A size of the surface-mount device is generally small. As a result, a heat dissipation area of the surface-mount device is limited, which is difficult to effectively dissipate heat. In addition, the surface-mount device is directly fastened to the circuit board, and there is no sufficient space for heat dissipation. However, the substrate in this application can help with heat dissipation of the power device, overcoming a problem of poor heat dissipation of the power device being in the form of the surface-mount device. In this way, the power conversion apparatus can use a power device in any form according to a requirement, thereby improving design flexibility of the power conversion apparatus.

According to a second aspect of this application, a power cabinet is provided. The power cabinet includes a cabinet body and a plurality of power conversion apparatuses, the plurality of power conversion apparatuses are located in the cabinet body, and the plurality of power conversion apparatuses are connected in parallel.

The power conversion apparatus in the cabinet can perform power conversion on input electric energy for output. The substrate can help with heat dissipation of the power device, and can also reduce a risk of interference to a signal caused by the second metal layer being electrified or the structure connected to the second metal layer being electrified. The power cabinet provided in this application includes the foregoing power conversion apparatus. Therefore, the power cabinet provided in this application and the power conversion apparatus in the foregoing technical solution can resolve the same technical problem and have same technical effects. Details are not described herein again.

### BRIEF DESCRIPTION OF DRAWINGS

FIG. 1 is a diagram of a structure of a power conversion apparatus according to an embodiment of this application;
FIG. 2 is a diagram of a structure of a power cabinet according to an embodiment of this application;
FIG. 3 is a diagram of a structure of another power cabinet according to an embodiment of this application;
FIG. 4 is a diagram of an internal structure of a power conversion apparatus according to an embodiment of this application;
FIG. 5 is a diagram of an internal structure of another power conversion apparatus according to an embodiment of this application;
FIG. 6 is a diagram of a structure and a location of a substrate according to an embodiment of this application;
FIG. 7 is a diagram of a structure of a second routing layer according to an embodiment of this application;
FIG. 8 is a diagram of a structure of a through hole according to an embodiment of this application;
FIG. 9 is a diagram of a structure of a metal structure according to an embodiment of this application;
FIG. 10 is a diagram of a structure of a filler according to an embodiment of this application;
FIG. 11 is a diagram of a location of another substrate according to an embodiment of this application;
FIG. 12 is a diagram of structures of three power devices according to an embodiment of this application;
FIG. 13 is a diagram of a location of still another substrate according to an embodiment of this application;
FIG. 14 is a diagram of a structure and a location of a heat sink according to an embodiment of this application;
FIG. 15 is a diagram of a structure and a location of another heat sink according to an embodiment of this application;
FIG. 16 is a diagram of a structure and a location of still another heat sink according to an embodiment of this application;
FIG. 17 is a diagram of an internal structure of still another power conversion apparatus according to an embodiment of this application;
FIG. 18 is a diagram of an internal structure of still another power conversion apparatus according to an embodiment of this application;
FIG. 19 is a diagram of a structure of another substrate according to an embodiment of this application; and
FIG. 20 is a diagram of a structure of still another substrate according to an embodiment of this application.

### Reference numerals:

100: power conversion apparatus; 1: apparatus housing; 11: opening; 2: circuit board; 21: first routing layer; 22: second routing layer; 23: through hole; 231: metal structure; 232: filler; 3: power device; 31: packaging housing; 32: die; 33: metal plate; 34: pin; 35: mounting plate; 4: main board; 5: substrate; 51: first metal layer; 52: first insulation layer; 53: second metal layer; 54: second insulation layer; 55: third metal layer; 56: boss; 6: heat sink; 61: heat conducting plate; 62: fin;
200: power cabinet; 201: cabinet body; 202: circuit breaker; 203: charging plug; 204: cable.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In this application, unless otherwise expressly specified and limited, orientations or position relationships indicated by terms such as "up", "down", "front", "back", "left", and "right" may include but are not limited to be defined with respect to orientations of components schematically placed in the accompanying drawings. These directional terms may be relative concepts, may be used for relative description and clarification, and may vary correspondingly based on changes of the placement orientations of the components in the accompanying drawings. Such terms cannot be understood as a limitation on this application.

In this application, the terms "first", "second", and the like are merely intended for a purpose of description, and are intended to distinguish between one element and another element, but cannot be understood as an indication or implication of relative importance or an implicit indication of a quantity of indicated technical features. Therefore, a feature limited by "first", "second", or the like may explicitly or implicitly include one or more features.

In this application, unless otherwise expressly specified and limited, "a plurality of" means two or more.

In addition, in this application, the term "example", "for example", or the like indicates giving an example, an illustration, or a description. Any embodiment or design scheme described as an "example" or "for example" in this application should not be construed as being more preferred or having more advantages than another embodiment or design scheme. Exactly, use of the term such as "example" or "for example" is intended to present a related concept in a specific manner.

In the accompanying drawings of embodiments of this application, entity structures such as components and assemblies are represented by guide lines. A structure including a plurality of components is represented by parentheses or guide lines with solid arrows. Hollow structures such as openings, holes, spaces, and chambers are represented by guide lines with hollow arrows.

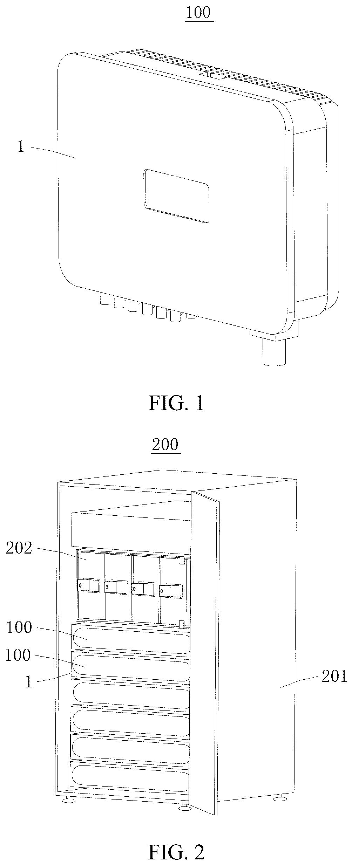

Embodiments of this application provide a power conversion apparatus 100. The power conversion apparatus 100 performs power conversion on input electric energy through an internal power conversion circuit for output. For example, the power conversion apparatus 100 can convert a direct current into an alternating current. For another example, the power conversion apparatus 100 can convert an alternating current into a direct current. For another example, the power conversion apparatus 100 can perform boost or buck conversion. The power conversion apparatus 100 in this application may be an inverter, a rectifier, an on-board charger (On-Board Charger, OBC), a power module (for example, a DC-DC module or an AC-DC module) in a charging pile, a small charging apparatus, or the like. FIG. 1 shows an example of a structure of a power conversion apparatus 100. With reference to FIG. 1, the power conversion apparatus 100 may be a rectifier.

In addition, the power conversion apparatus 100 may be further used in a power cabinet 200. For example, FIG. 2 shows an example of a structure of one power cabinet 200. With reference to FIG. 2, the power cabinet 200 may be a cabinet-type uninterruptible power supply (Uninterruptible Power Supply, UPS). The power cabinet 200 includes a cabinet body 201, a plurality of power conversion apparatuses 100 connected in parallel, a plurality of circuit breakers 202, and the like. The plurality of power conversion apparatuses 100 may include a plurality of AC-DC modules; or the plurality of power conversion apparatuses 100 may include a plurality of DC-DC modules and a plurality of AC-DC modules. The plurality of power conversion apparatuses 100 are stacked in the cabinet body 201 along a height direction of the cabinet body 201, and the plurality of circuit breakers 202 are located above the plurality of power conversion apparatuses 100.

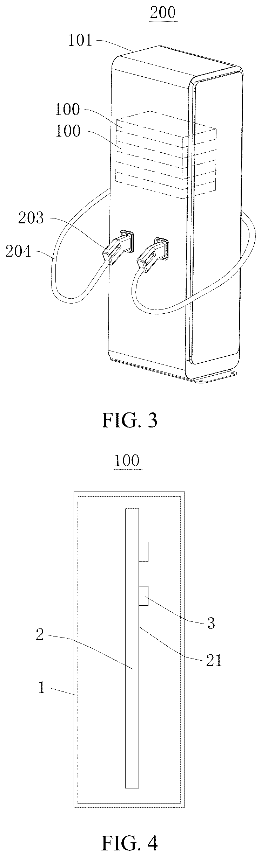

For another example, FIG. 3 shows an example of a structure of another power cabinet 200. With reference to FIG. 3, the power cabinet 200 may alternatively be a charging pile. The power cabinet 200 includes a cabinet body 201, a plurality of power conversion apparatuses 100 connected in parallel, at least one charging plug 203 (a plurality of charging plugs 203 are shown in FIG. 3), at least one cable 204 (a plurality of cables 204 are shown in FIG. 3), and the like. The plurality of power conversion apparatuses 100 connected in parallel are located in the cabinet body 201 of the power cabinet 200. The charging plug 203 is electrically connected to the plurality of power conversion apparatuses 100 through corresponding cables 204.

FIG. 4 shows an example of an internal structure of a power conversion apparatus 100. With reference to FIG. 4, the power conversion apparatus 100 includes an apparatus housing 1. The apparatus housing 1 may be any housing with a housing function. In addition, the power conversion apparatus 100 further includes a circuit board 2 and a power device 3 fastened to the circuit board 2. For example, the circuit board 2 includes a first routing layer 21 facing the power device 3, the power device 3 is fastened (for example, soldered) to the first routing layer 21, and the power device 3 is electrically connected to the first routing layer 21. Both the circuit board 2 and the power device 3 are located in the apparatus housing 1.

In some embodiments, the power device 3 may be in a form of a surface-mount device. This facilitates development of the power device 3 toward miniaturization and high density, and can also improve reliability of the power device 3. The power device 3 in the form of a surface-mount device may be soldered to a pad of the first routing layer 21 (the pad may be an exposed part of the first routing layer 21) by using solder, and a pin 34 of the power device 3 is fastened to a surface that is of the pad and that faces the power device 3. In some other embodiments, the power device 3 may alternatively be another suitable packaged device.

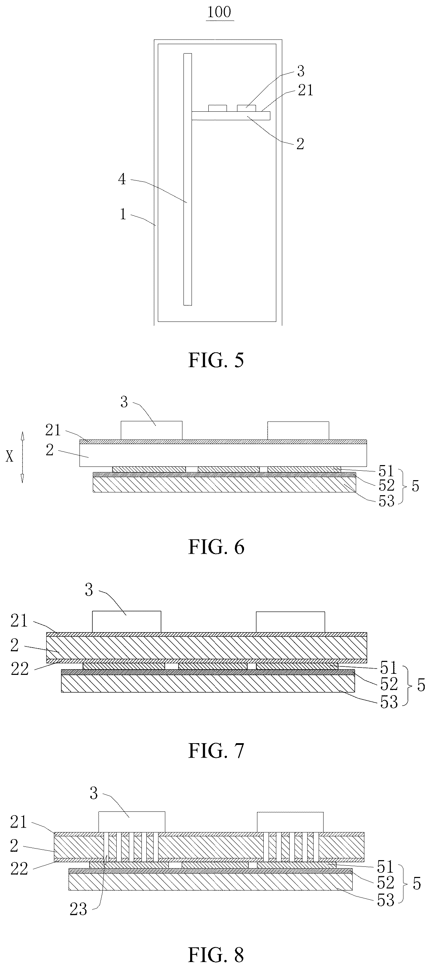

FIG. 5 shows an example of an internal structure of another power conversion apparatus 100. With reference to FIG. 5, a difference from the embodiment shown in FIG. 4 is that the circuit board 2 fastened to the power device 3 is fastened to another circuit board (which may be referred to as a main board 4) through an adapter structure (for example, a pin or a metal conductor). For example, the adapter structure connects the first routing layer 21 to the another circuit board (the main board 4). In the embodiment shown in FIG. 5, a part of power devices 3 of a power conversion circuit are disposed on the circuit board 2, and another device of the power conversion circuit, such as an inductor or a capacitor, is disposed on the another circuit board (the main board 4). In addition, a control circuit for controlling the power device 3 and the like are further disposed on the another circuit board (the main board 4).

The circuit board 2 fastened to the power device 3 and the another circuit board (the main board 4) may be mounted at any proper angle. For example, in the embodiment shown in FIG. 5, the circuit board 2 fastened to the power device 3 is vertically fastened to the another circuit board (the main board 4). In other words, either surface of the circuit board 2 fastened to the power device 3 is perpendicular ("perpendicular" herein does not indicate absolute perpendicularity but allows for a tolerance of ±10°) to either surface of the another circuit board (the main board 4). In some other embodiments, the circuit board 2 fastened to the power device 3 is parallel to the another circuit board (the main board 4). In other words, either surface of the circuit board 2 fastened to the power device 3 is parallel ("parallel" herein allows for a tolerance of ±10°) to either surface of the another circuit board (the main board 4).

During operation of the power conversion apparatus 100, the power device 3 generates a considerable amount of heat. Therefore, in this application, the power conversion apparatus 100 further includes a substrate 5. FIG. 6 shows an example of a structure and a location of the substrate 5. With reference to FIG. 6, the substrate 5 can help with heat dissipation of the power device 3. The substrate 5 is located in the apparatus housing 1 (for a structure of the apparatus housing 1, refer to FIG. 4 or FIG. 5). Still with reference to FIG. 6, the substrate 5 includes a first metal layer 51, a first insulation layer 52, and a second metal layer 53, the first insulation layer 52 is fastened between the first metal layer 51 and the second metal layer 53, and the first metal layer 51 is connected to the circuit board 2.

The first metal layer 51 and the second metal layer 53 are both made of metal, and have a strong heat conduction capability. Heat from the power device 3 is transferred to the circuit board 2, and then from the circuit board 2 to the substrate 5. The heat is transferred outward through the substrate 5 that has a strong heat conduction capability. Moreover, the first insulation layer 52 of the substrate 5 can separate the first metal layer 51 from the second metal layer 53. This reduces a possibility that the first metal layer 51 and the second metal layer 53 are electrically connected to each other. When the first metal layer 51 is electrified (for example, when the circuit board 2 or the power device 3 is electrically connected to the first metal layer 51), a possibility that the second metal layer 53 and a structure connected to the second metal layer 53 (for example, an auxiliary heat dissipation structure) are electrified can be reduced through the first insulation layer 52, thereby reducing interference to a signal (for example, a signal from a drive circuit used to drive the power device 3, or a signal from the control circuit used to control the power device 3).

In other words, the substrate 5 in this application can help with heat dissipation of the power device 3, which effectively dissipates the heat from the power device 3 while reducing a risk of interference to a signal caused by the second metal layer 53 being electrified or the structure connected to the second metal layer 53 being electrified.

In addition, when the power device 3 is a surface-mount device, the substrate 5 can help with heat dissipation of the power device 3, overcoming a problem of poor heat dissipation of the power device 3 being in a form of a surface-mount device. In this way, the power conversion apparatus 100 can use a power device 3 in any form (a surface-mount device or a plug-in device) according to a requirement, thereby improving design flexibility of the power conversion apparatus 100.

Materials of the first metal layer 51 and the second metal layer 53 may be any suitable materials, and the materials of first metal layer 51 and the second metal layer 53 may be the same or different, provided that the first metal layer 51 and the second metal layer 53 are both made of metal. In some embodiments, if the first metal layer 51 needs to be soldered to the circuit board 2, the material of the first metal layer 51 may be a metal material conducive to soldering, for example, copper. In some other embodiments, if costs or a weight needs to be controlled, the material of the second metal layer 53 may be a material that meets design requirements, for example, aluminum. In some other embodiments, if another structure (for example, an auxiliary heat dissipation structure) needs to be connected to the second metal layer 53, the material of the second metal layer 53 may be a metal material conducive to soldering, for example, copper, or the material of the second metal layer 53 may be a metal material not conducive to soldering (the material is selected for another purpose, for example, cost, weight, heat conduction capability, or the like), and electroplating is performed on a surface that is of the second metal layer 53 and that needs to be soldered to the another structure (for example, a surface that is of the second metal layer 53 and that is away from the first insulation layer 52), so that the surface of the second metal layer 53 is electroplated with a material conducive to soldering. This facilitates fastening by soldering between the second metal layer 53 and the another structure.

In addition, in some embodiments, the first metal layer 51 may also include a plurality of mutually insulated metal sheets, and the plurality of metal sheets that are insulated from each other jointly form the first metal layer 51. In these embodiments, the first metal layer 51 is similar to the routing layer of the circuit board 2, and the first insulation layer 52 may also reduce a possibility that the plurality of metal sheets are electrically connected to each other. In some other embodiments, the first metal layer 51 may be a complete metal plate.

A material of the first insulation layer 52 may be any suitable insulation material. For example, the material of the first insulation layer 52 includes polypropylene (PP). In other words, the first insulation layer 52 is a PP layer. Polypropylene has good insulation performance, and has a stronger heat conduction capability than another insulation material (for example, polyimide). The first insulation layer 52 of the substrate 5 includes polypropylene. In this way, the first metal layer 51 and the second metal layer 53 are insulated from each other, thermal resistance between the first metal layer 51 and the second metal layer 53 is reduced, and a heat dissipation capability of the substrate 5 is improved.

Both the first metal layer 51 and the second metal layer 53 in the substrate 5 have a strong heat conduction capability, and the first insulation layer 52 for shielding has a weak heat conduction capability. Therefore, in some embodiments, with reference to FIG. 6, a thickness of the first metal layer 51 and a thickness of the second metal layer 53 may be large, and a thickness of the first insulation layer 52 may be small, to improve the heat conduction capability of the substrate 5. For example, the thickness of the first metal layer 51 and the thickness of the second metal layer 53 are both greater than the thickness of the first insulation layer 52. In some other embodiments, the thickness of the first metal layer 51 may be equal to the thickness of the first insulation layer 52 or less than the thickness of the first insulation layer 52.

It should be noted that, the thickness of the first metal layer 51, the thickness of the first insulation layer 52, and the thickness of the second metal layer 53 are sizes of the three layers in thickness directions of the first metal layer 51, the first insulation layer 52, and the second metal layer 53 (an X direction in FIG. 6).

In some embodiments, the first metal layer 51 may be soldered to the circuit board 2. For example, the circuit board 2 further includes a second routing layer 22 facing the substrate 5. FIG. 7 shows an example of a structure of the second routing layer 22. A material of the second routing layer 22 is metal (for example, copper). The metallic second routing layer 22 facilitates soldering with the metallic first metal layer 51. Soldering is a simple fastening manner that facilitates stable fastening of the substrate 5 to the circuit board 2, reducing a possibility that the substrate 5 is separated from the circuit board 2. In addition, through soldering, thermal resistance between the substrate 5 and the circuit board 2 may also be small, which facilitates heat transfer between the substrate 5 and the circuit board 2.

In some other embodiments, the substrate 5 and the circuit board 2 may alternatively be fastened in another manner. For example, the substrate 5 and the circuit board 2 may alternatively be fastened by using a bolt (or another fastener), to implement stable connection between the substrate 5 and the circuit board 2.

In some embodiments, a hole may be further provided to accelerate heat transfer between the power device 3 and the substrate 5. For example, the circuit board 2 includes a through hole 23. FIG. 8 shows an example of a structure of the through hole 23. With reference to FIG. 8, the through hole 23 is located between the power device 3 and the first metal layer 51, one port of the through hole 23 faces the power device 3, and the other port of the through hole 23 faces the first metal layer 51, so that heat conduction between the power device 3 and the substrate 5 can be accelerated. In this way, the heat from the power device 3 can be quickly transferred across the circuit board 2 to the first metal layer 51 of the substrate 5, and then the heat is transferred outward through the substrate 5, thereby improving heat dissipation efficiency of the power device 3.

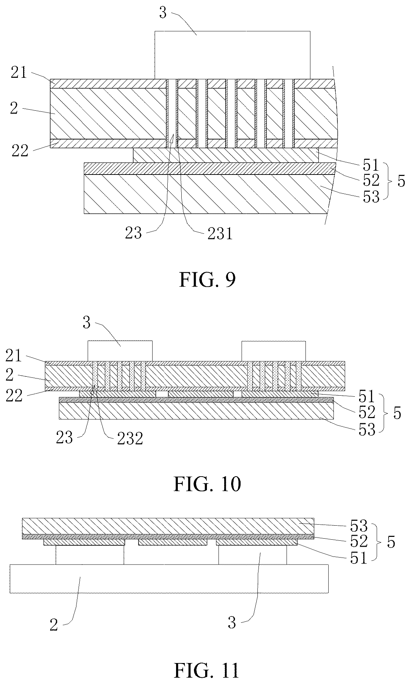

The through hole 23 may be any suitable hole-like structure. In addition, in some embodiments, an inner surface of the through hole 23 is provided with a metal structure 231 (for example, the through hole 23 is a metal hole) and a metal layer. FIG. 9 shows an example of the metal structure 231. With reference to FIG. 9, the metal structure 231 extends to a side that is of the circuit board 2 and that faces the substrate 5, and the metal structure 231 is connected (for example, soldered) to the first metal layer 51. The metal structure 231 has a strong heat conduction capability. The metal structure 231 helps the through hole 23 dissipate heat for the power device 3, so that heat transfer between the power device 3 and the substrate 5 can be accelerated. In this way, the heat from the power device 3 is transferred to the substrate 5 more quickly through the metal structure 231, which further improves heat dissipation efficiency of the power device 3.

In addition, when the inner surface of the through hole 23 includes the metal structure 231, the circuit board 2 may be a multi-layer circuit board. The circuit board 2 has a plurality of routing layers arranged along a thickness direction of the circuit board 2. The metal structure 231 may be further configured to electrically connect the plurality of routing layers of the circuit board 2 (which may include the first routing layer 21 and a second routing layer 22).

In some embodiments, a filler 232 is provided in the through hole 23. FIG. 10 shows an example of a structure of the filler 232. With reference to FIG. 10, heat transfer can be further accelerated through the filler 232. For example, the filler 232 includes a metal block. The through hole 23 is filled with the metal block (the through hole 23 may be fully filled with the metal block, or the metal block may be merely inserted into the through hole 23). The metal block is connected to the first metal layer 51. The metal block is made of metal and has a strong heat conduction capability. In this way, the metal block can help the through hole 23 conduct the heat from the power device 3, thereby improving heat dissipation efficiency of the power device 3. For another example, the filler 232 includes resin. The resin has a stronger heat conduction capability than air, and heat transfer on the resin is faster than heat transfer in air. The resin can quickly transfer the heat from the power device 3 to the substrate 5 and help accelerate heat transfer on the circuit board 2.

In addition, the filler 232 can further seal the through hole 23. For example, when the through hole 23 goes through the pad on the circuit board 2 (the pad is a part of the first routing layer 21 on the circuit board 2 for soldering the power device 3), the filler 232 can reduce a possibility that the solder (for connecting the pad and the power device 3) enters the through hole 23, so that there is more solder between the power device 3 and the pad. This facilitates stable connection between the power device 3 and the circuit board 2.

It should be noted that, when the through hole 23 is filled with the filler 232, the metal structure 231 may be provided on the inner surface of the through hole 23 (the through hole 23 is a metal hole), and the metal structure 231 surrounds the filler 232. Alternatively, when the through hole 23 is filled with the filler 232, the metal structure 231 may not be provided on the inner surface of the through hole 23 (the through hole 23 is a non-metal hole).

In some other embodiments, the substrate 5 may alternatively be connected to the power device 3. For example, FIG. 11 shows an example of a location of another substrate 5. With reference to FIG. 11, the substrate 5 is located on a side that is of the power device 3 and that is away from the circuit board 2, and a first metal layer 51 of the substrate 5 is fastened to the power device 3. In this way, heat from the power device 3 is directly transferred to the substrate 5 (without passing through the circuit board 2), and then transferred outward through the substrate 5. This shortens a heat dissipation path of the power device 3 and improves a heat dissipation effect of the power device 3.

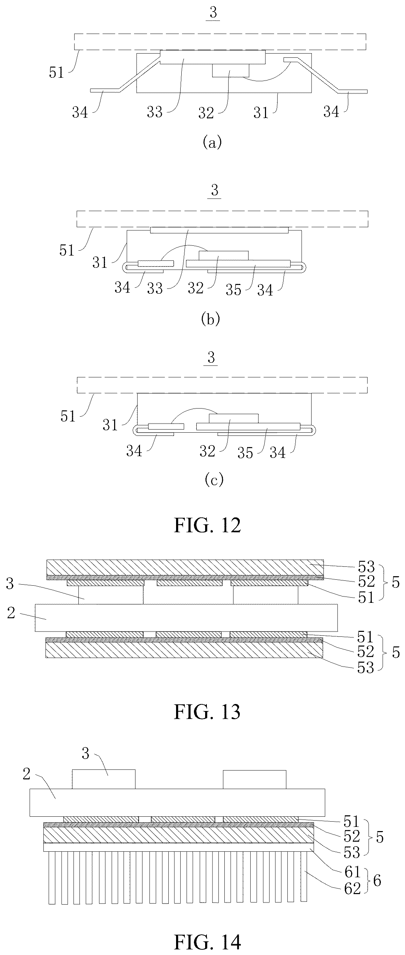

The substrate 5 can implement heat dissipation of the power device 3 as long as the substrate 5 is connected to the power device 3. A specific part of the power device 3 to which the substrate 5 is connected may be set according to a requirement. For example, FIG. 12 shows an example of structures of three power devices 3. With reference to FIG. 11 and (a) in FIG. 12, the power device 3 includes a packaging housing 31, a die 32 (die), a metal plate 33, and a plurality of pins 34. The die 32 is located in the packaging housing 31, and the die 32 is fastened to the metal plate 33. A routing layer may be disposed on a surface of the metal plate 33 that is used for fastening the die 32. The metal plate 33 protrudes from the inside of the packaging housing 31 to the outside of the packaging housing 31 (a side that is away from the circuit board 2). A part that is of the metal plate 33 and that protrudes to the outside of the packaging housing 31 is connected to the first metal layer 51. The metal plate 33 of the power device 3 can help the power device 3 dissipate heat outward, so that heat inside the packaging housing 31 is quickly transferred to the outside of the packaging housing 31 through the metal plate 33. In other words, the heat inside the packaging housing 31 is quickly transferred to the substrate 5, thereby improving heat dissipation efficiency of the power device 3.

In some other embodiments, with reference to FIG. 11 and (b) in FIG. 12, the metal plate 33 may not be a plate for fastening the die 32, and the die 32 is fastened to a dedicated mounting plate 35. For example, the mounting plate 35 is a ceramic copper-clad plate (Direct Copper Bond, DCB). In these embodiments, the metal plate 33 is a plate that helps with heat dissipation of the power device 3. The metal plate 33 protrudes from the inside of the packaging housing 31 to the side that is of the packaging housing 31 and that is away from the circuit board 2. The part that is of the metal plate 33 and that protrudes to the outside of the packaging housing 31 is connected to the first metal layer 51. In this way, the heat inside the packaging housing 31 is quickly transferred to the substrate 5 through the metal plate 33. In these embodiments, the metal plate 33 and the mounting plate 35 may be electrically connected to each other or may be insulated from each other.

In some other embodiments, with reference to FIG. 11 and (c) in FIG. 12, the substrate 5 is connected to a surface that is of the packaging housing 31 and that is away from the circuit board 2.

In addition, in some embodiments, two substrates 5 may be disposed. FIG. 13 shows an example of a location of still another substrate 5. With reference to FIG. 13, one substrate 5 (the lower substrate 5 in FIG. 13) is located on a side that is of the circuit board 2 and that is away from the power device 3, a first metal layer 51 of the substrate 5 is connected to the circuit board 2; and the other substrate 5 (the upper substrate 5 in FIG. 13) is located on a side that is of the power device 3 and that is away from the circuit board 2, and a first metal layer 51 of the other substrate 5 is connected to the power device 3. For the other substrate 5 connected to the power device 3, heat from the power device 3 can be transferred to the other substrate 5, and then transferred outward through the other substrate 5. For the substrate 5 connected to the circuit board 2, the heat from the power device 3 is transferred to the circuit board 2, then transferred to the substrate 5 through the circuit board 2, and finally transferred outward through the substrate 5. A plurality of substrates 5 are disposed, so that a heat dissipation capability of the power device 3 can be further improved.

In some embodiments, a structure that helps with heat dissipation of the substrate 5 may be further disposed. For example, the power conversion apparatus 100 includes a heat sink 6. FIG. 14 shows an example of a location of the heat sink 6. The substrate 5 in FIG. 14 is located on a side that is of the circuit board 2 and that is away from the power device 3. The heat sink 6 includes a heat conducting plate 61 and a plurality of fins 62. The heat conducting plate 61 is located on a side that is of the substrate 5 and that is away from the power device 3, and is fastened to the substrate 5. For example, the heat conducting plate 61 is fastened to a second metal layer 53. The plurality of fins 62 are fastened to a surface that is of the heat conducting plate 61 and that is away from the substrate 5.

The substrate 5 may be connected to the heat conducting plate 61 of the heat sink 6 in any manner. For example, the substrate 5 is soldered to the heat conducting plate 61. Through soldering, which is a simple connection manner, the heat sink 6 can be stably connected to the substrate 5 and therefore help the substrate 5 dissipate heat. After the heat from the power device 3 is transferred to the substrate 5, the heat is transferred to the heat conducting plate 61 of the heat sink 6 through the substrate 5, and the heat is transferred from the heat conducting plate 61 to the plurality of fins 62. A gap between two adjacent fins 62 facilitates heat exchange between the fins 62 and air, thereby improving heat dissipation efficiency of the power device 3.

In addition, if a structure similar to the fins 62 is directly formed on the substrate 5, a length of the structure (a size of the structure in a thickness direction of the second metal layer 53) may be short due to a limitation of a manufacturing device of the substrate 5, which affects a heat dissipation effect of the power device 3. Therefore, to make the structure similar to the fins 62 on the substrate 5 meet a heat dissipation requirement of the power device 3, it is necessary to extend the length of the structure in another manner, which also increases manufacturing costs. However, the heat sink 6 is additionally provided, so that the heat sink 6 can be independently produced according to a requirement. In this way, a size and a shape of the heat sink 6 are more flexible, which is conducive to production and manufacturing. As a result, manufacturing costs are reduced while effective heat dissipation of the power device 3 is maintained.

In addition, because the substrate 5 includes a first insulation layer 52, a possibility that a first metal layer 51 and a second metal layer 53 are electrically connected to each other can be reduced through the first insulation layer 52, thereby reducing a possibility that the heat sink 6 connected to the second metal layer 53 is electrified, and reducing a risk of interference to a signal caused by the heat sink 6 being electrified. In scenarios such as salt fogs and wet dust, a risk of a short circuit between different electrical networks on the circuit board 2 and the heat sink 6 is also reduced.

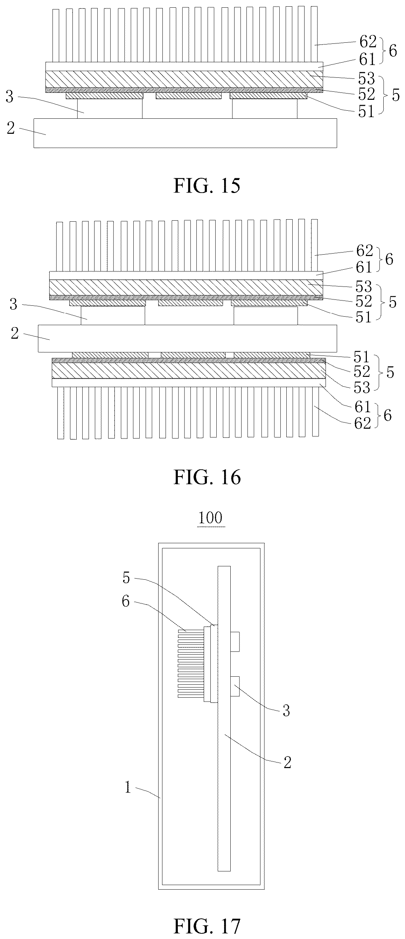

In an embodiment in which the substrate 5 is connected to the power device 3, the substrate 5 may also be connected to a heat sink 6. For example, FIG. 15 shows an example of a location of another heat sink 6. With reference to FIG. 15, the heat sink 6 is fastened to a side that is of the substrate 5 and that is away from the power device 3.

In addition, in an embodiment in which there are a plurality of substrates 5, one heat sink 6 may be disposed, and the heat sink 6 is connected to one of the substrates 5. Alternatively, in an embodiment in which there are a plurality of substrates 5, a plurality of heat sinks 6 may be disposed. For example, FIG. 16 shows an example of a location of still another heat sink 6. With reference to FIG. 16, the one substrate 5 is located on the side that is of the circuit board 2 and that is away from the power device 3, the another substrate 5 is located on the side that is of the power device 3 and that is away from the circuit board 2, and one heat sink 6 is fastened to a side that is of each substrate 5 and that is away from the power device 3.

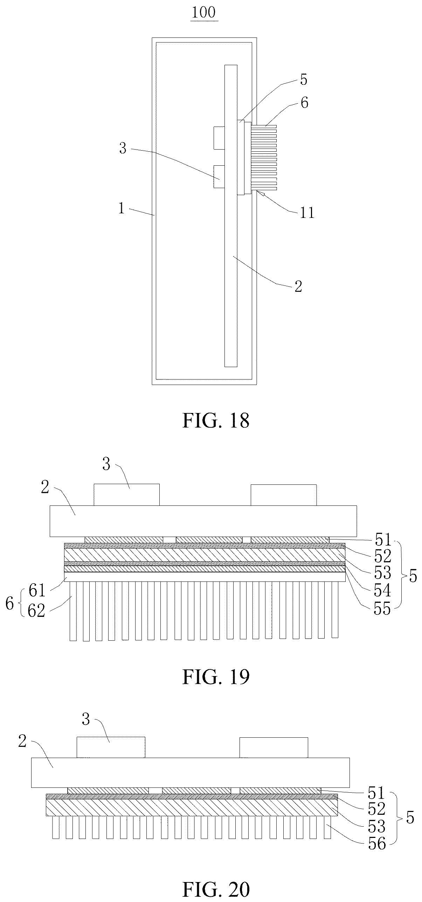

When the power device 3 further includes a heat sink 6, a location of the heat sink 6 relative to the apparatus housing 1 may be set according to a requirement. For example, FIG. 17 shows an example of a diagram of an internal structure of still another power conversion apparatus 100. With reference to FIG. 17, the heat sink 6 is located in the apparatus housing 1. For another example, FIG. 18 is an example of a diagram of an internal structure of still another power conversion apparatus 100. With reference to FIG. 18, an opening 11 is provided on the apparatus housing 1, a part of a heat sink 6 is in the apparatus housing 1, and another part (for example, a plurality of fins 62) of the heat sink 6 extends out of the apparatus housing 1 through the opening 11.

It should be noted that FIG. 17 and FIG. 18 are both shown by using an example in which the substrate 5 is connected to the circuit board 2. When the substrate 5 is connected to the power device 3 (for example, in the case shown in FIG. 15), the heat sink 6 may be completely located in the apparatus housing 1, or the heat sink 6 may have a part in the apparatus housing 1 and have another part extending out of the apparatus housing 1 through the opening 11. In addition, when a plurality of substrates 5 and a plurality of heat sinks 6 are disposed, if two heat sinks 6 are respectively located on different sides of the circuit board 2 (for example, in the case shown in FIG. 16), in an embodiment, the two heat sinks 6 may be completely located in the apparatus housing 1; and in another embodiment, one heat sink 6 of the two heat sinks 6 may be completely located in the apparatus housing 1, and the other heat sink 6 may have a part in the apparatus housing 1 and have another part extending out of the apparatus housing 1 through the opening 11.

In an embodiment, the substrate 5 may further include more insulation layers and more metal layers. For example, the substrate 5 further includes a second insulation layer 54 and a third metal layer 55. FIG. 19 shows an example of a structure of another substrate 5. With reference to FIG. 19, the second insulation layer 54 is fastened between the second metal layer 53 and the third metal layer 55. A material of the second insulation layer 54 may be any suitable insulation material. For example, the material of the second insulation layer 54 includes polypropylene (PP). In this way, the second metal layer 53 and the third metal layer 55 are insulated from each other, thermal resistance between the second metal layer 53 and the third metal layer 55 is reduced, and a heat dissipation capability of the substrate 5 is improved. Disposing a plurality of insulation layers (the first insulation layer 52 and the second insulation layer 54) may further reduce a possibility that a structure connected to the substrate 5 (for example, a heat sink 6) is electrified, and further reduce a risk of interference to a signal caused by the heat sink 6 being electrified.

In addition, a material of the third metal layer 55 may be any suitable material, provided that the material of the third metal layer 55 is metal. In addition, the material of the first metal layer 51, the material of the second metal layer 53, and the material of the third metal layer 55 may be the same or different. In some cases, one side of the substrate 5 needs to be connected to the power device 3 or the circuit board 2, and the other side of the substrate 5 may be connected to an auxiliary heat dissipation structure such as the heat sink 6. Therefore, the materials of the first metal layer 51, the second metal layer 53, and the third metal layer 55 may be separately selected. For example, the materials of the first metal layer 51 and the third metal layer 55 are materials conducive to soldering (for example, copper); and the material of the second metal layer 53 is a material with a lower cost (for example, aluminum), or the material of the second metal layer 53 is a material with a lighter weight.

In other words, when the substrate 5 includes a plurality of metal layers (for example, the first metal layer 51, the second metal layer 53, and the third metal layer 55), different materials may be selected for the metal layers according to a requirement. This facilitates connection (for example, soldering) between the substrate 5 and another structure, with other factors such as cost, weight, and heat conduction capability of the substrate 5 taken into consideration, allowing for a more flexible design of the substrate 5.

In the embodiment shown in FIG. 19, when the power device 3 further includes the heat sink 6, the heat sink 6 is fastened (for example, soldered) to the third metal layer 55.

In some other embodiments, the substrate 5 further includes a plurality of bosses 56 (which may be understood as a structure similar to fins 62) to help with heat dissipation. FIG. 20 shows an example of a structure of another substrate 5. With reference to FIG. 20, the plurality of bosses 56 face away from the circuit board 2. For example, in the embodiment shown in FIG. 20, the plurality of bosses 56 are fastened (integrally connected or soldered) to the second metal layer 53. It may be understood that, in the embodiment in which the substrate 5 includes the third metal layer 55, the plurality of bosses 56 are fastened to the third metal layer 55. After the heat from the power device 3 is transferred to the substrate 5, a gap between two adjacent bosses 56 facilitates heat exchange between the bosses 56 and air, thereby improving heat dissipation efficiency of the power device 3.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion apparatus, configured to perform power conversion on input electric energy for output, comprising:
an apparatus housing;
a circuit board, wherein the circuit board is fastened in the apparatus housing;
a power device, wherein the power device is fastened to the circuit board; and
a substrate, wherein the substrate is located in the apparatus housing, the substrate comprises a first metal layer, a first insulation layer, and a second metal layer, the first insulation layer is fastened between the first metal layer and the second metal layer, and the first metal layer is connected to the circuit board or the power device.

2. The power conversion apparatus according to claim 1, wherein the substrate is located on a side that is of the circuit board and that is away from the power device, the circuit board comprises a first routing layer facing the power device and a second routing layer facing the substrate, the power device is fastened to the first routing layer, and the second routing layer is connected to the first metal layer.

3. The power conversion apparatus according to claim 1 or 2, wherein the first metal layer is connected to a board surface that is of the circuit board and that is away from the power device, the circuit board comprises a through hole, one port of the through hole faces the power device, and the other port of the through hole faces the first metal layer.

4. The power conversion apparatus according to claim 3, wherein an inner surface of the through hole comprises a metal structure, and the metal structure extends out of the through hole and is connected to the first metal layer.

5. The power conversion apparatus according to claim 3 or 4, wherein there is a filler in the through hole; and the filler comprises a metal block, and the metal block is connected to the first metal layer; or the filler comprises resin.

6. The power conversion apparatus according to claim 1, wherein the power device comprises a packaging housing and a metal plate, the metal plate protrudes from inside of the packaging housing to a side that is of the packaging housing and that is away from the circuit board, the substrate is located on a side that is of the power device and that is away from the circuit board, and the metal plate is connected to the first metal layer.

7. The power conversion apparatus according to any one of claims 1 to 6, wherein the substrate further comprises a second insulation layer and a third metal layer, and the second insulation layer is fastened between the second metal layer and the third metal layer.

8. The power conversion apparatus according to any one of claims 1 to 7, wherein the power conversion apparatus comprises a heat sink, the heat sink is located in the apparatus housing or is at least partially outside the apparatus housing, the heat sink comprises a heat conducting plate and a plurality of fins, the heat conducting plate is located on a side that is of the substrate and that is away from the power device, and is fastened to the substrate, and the plurality of fins are fastened to a surface that is of the heat conducting plate and that is away from the substrate.

9. The power conversion apparatus according to any one of claims 1 to 8, wherein a thickness of the first metal layer and a thickness of the second metal layer are both greater than a thickness of the first insulation layer.

10. The power conversion apparatus according to any one of claims 1 to 9, wherein a material of the first insulation layer comprises polypropylene.

11. A power cabinet, comprising a cabinet body and a plurality of power conversion apparatuses according to any one of claims 1 to 10, wherein the plurality of power conversion apparatuses are located in the cabinet body, and the plurality of power conversion apparatuses are connected in parallel.
